# FASCICULE DE BREVET EUROPEEN

(11) **EP 1 604 556 B1**
(45) Date de publication et mention de la délivrance du brevet: **17.09.2008**
(21) Numéro de dépôt: 03796090.3
(22) Date de dépôt: 10.12.2003
(51) Int. Cl.: H05K 7/14

(54) **CARTE ELECTRONIQUE A STRUCTURE HAUBANEE**
ELEKTRONISCHE KARTE MIT DRAHTVERSPANNUNGSSTRUKTUR
ELECTRONIC CARD WITH WIRE-BRACED STRUCTURE

(30) Priorité: 13.12.2002 FR 0215844
(43) Date de publication de la demande: 14.12.2005
(73) Titulaire: THALES, 92200 Neuilly sur Seine (FR)
(72) Inventeur: LAVERGNE, Catherine, Thales Intellectual Property, 94117 Arcueil (FR); CASAGRANDE, Mathieu, Thales Intellectual Property, 94117 Arcueil (FR)
(74) Mandataire: Esselin, Sophie
(86) Numéro de dépôt international: PCT/EP2003/050973
(87) Numéro de publication internationale: WO 2004/056163

(56) Documents cités:
- EP-A- 0 200 597
- US-A- 4 386 390
- US-A1- 2002 141 165
- US-B1- 6 260 265

## Description

Le domaine de l'invention est celui des calculateurs électroniques devant fonctionner en environnement mécanique sévère. Un des principaux domaines d'application concerne les calculateurs des systèmes embarqués d'avionique et d'hélivionique fonctionnant en environnement vibratoire élevé.

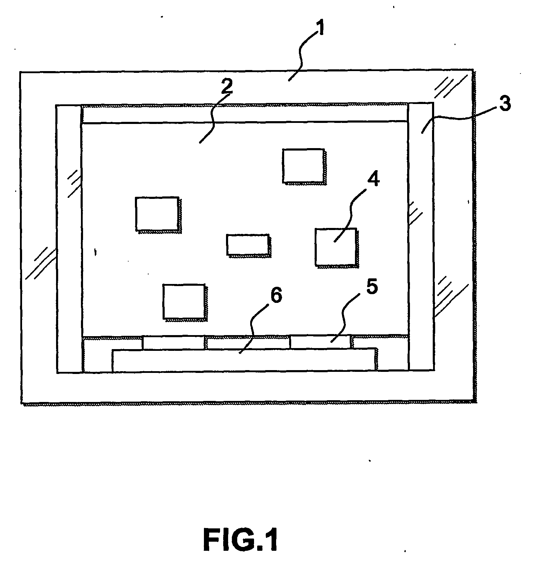

La figure 1 montre le schéma simplifié d'un calculateur électronique. Celui-ci comprend essentiellement un bâti mécanique 1 et une ou plusieurs cartes électroniques 2. Chaque carte électronique 2 est maintenue mécaniquement dans le bâti 1 par des glissières 3. La connexion électrique de chaque carte électronique 2 est réalisée au moyen d'un ou de plusieurs connecteurs 5 reliés à une carte électronique commune 6 dite carte-mère ou carte « fond de panier ». Chaque carte électronique comprend un circuit imprimé et des composants électroniques 4.

Pour certaines applications, ce type d'équipement est soumis à des environnements mécaniques sévères. En utilisation aéronautique, les niveaux vibratoires peuvent être très importants, en particulier pour certains types d'aéronefs comme les avions d'armes ou les aéronefs à voilure tournante et également dans certaines zones de l'appareil comme les réacteurs ou les turbines de propulsion.

Ces niveaux vibratoires engendrent des sollicitations mécaniques importantes au niveau des cartes électroniques qui peuvent avoir des conséquences graves sur leur fonctionnement. Les principaux problèmes sont :
- La tenue des soudures des composants. Certains composants de grande dimension comme les condensateurs de grande capacité sont particulièrement sensibles aux vibrations.
- La tenue des pattes de connexion des composants. Certains composants comme les microprocesseurs, les composants électroniques non programmables de type ASIC (Application Specific Integrated Circuit) ou programmables de type EPLD (Erasable Programmable Logic Device) ont un grand nombre de sorties de connexion de très faible dimension qui les rendent plus vulnérables aux vibrations.
- Les chocs possibles. Soumise aux vibrations, une carte électronique, surtout si elle est de grande dimension, peut se déformer suffisamment jusqu'à heurter soit une autre carte soit les parois du bâti lui-même.
- L'usure possible de la connectique. Les contacts et les broches d'interconnection des connecteurs de la carte soumis aux vibrations de la carte vont frotter dans leur logements, pouvant provoquer des faux contacts ou des changements de leur propriété électrique.

Ces phénomènes peuvent encore être amplifiés lorsque les fréquences de résonance propres de la carte correspondent aux fréquences propres de la structure porteuse du bâti ou à certaines fréquences typiques de l'aéronef (fréquences liées à la rotation du rotor dans le cas d'un aéronef à voilure tournante, fréquences liées au vol avec tir canon pour les aéronefs militaires,...)

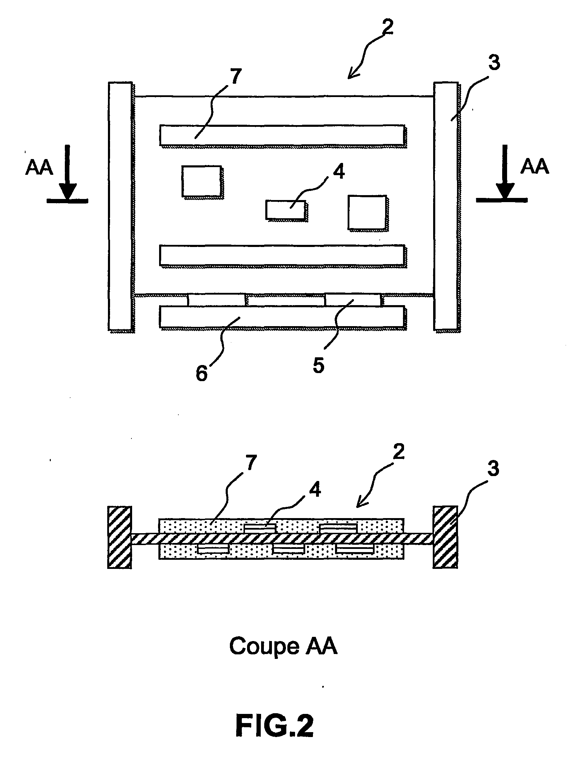

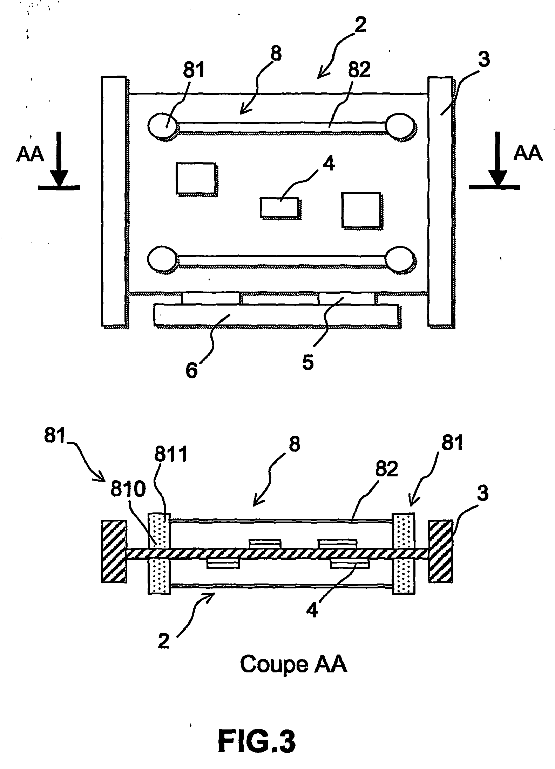

Pour diminuer les problèmes liées aux vibrations, des raidisseurs 7 sont montés sur les cartes électroniques comme il est indiqué en figure 2 où deux raidisseurs parallèles sont montés sur la longueur de la carte électronique 2. Généralement, ces raidisseurs sont des renforts mécaniques épais(figure 3 - Coupe AA).

Ces renforts permettent de diminuer les perturbations mécaniques engendrées par les vibrations. Ils présentent cependant les inconvénients suivants :
- leur masse n'est pas négligeable. Or la contrainte de masse est souvent un paramètre dimensionnant pour les applications aéronautiques.
- Les cartes électroniques dissipent généralement une puissance thermique importante et le boîtier peut également se trouver dans un environnement à température élevée, la température de la carte électronique peut donc être très importante (voisine de 100°). Or, la durée de vie des composants est directement liée à leur température de fonctionnement. Par conséquent, les cartes électroniques sont généralement refroidies. Le refroidissement peut se faire soit par air, soit par des fluides caloporteurs. Les raidisseurs entravent alors la libre circulation de l'air ou des fluides caloporteurs autour des cartes électroniques, ce qui perturbe leur bon refroidissement.
- Les raidisseurs ont une forme bien définie et occupent nécessairement une certaine surface sur la carte électronique, ce qui diminue d'autant les possibilités d'implantation des composants électroniques, complique la réalisation du circuit imprimé et diminue la surface occupée par les composants électroniques.
- Les fréquences de résonance de la carte électronique ne peuvent pas être modifiées simplement par les raidisseurs.

L'invention consiste à remplacer les renforts mécaniques par des structures à haubans qui, tout en remplissant les mêmes fonctions, n'en présentent pas les inconvénients.

Les structures à haubans sont largement utilisées en architecture et dans le domaine de la construction maritime. Ce sont généralement des structures importantes de l'ordre de plusieurs mètres. L'emploi de structures haubanées dans le domaine de l'électronique est cependant nouveau et apporte des avantages significatifs par rapport aux raidisseurs mécaniques classiques. En effet, les structures haubanées sont, par nature, des structures légères, aériennes, et ayant un faible empattement sur la carte électronique. II est, d'autre part, possible en réglant la tension mécanique des haubans de déplacer les fréquences de surtension de la carte électronique et de les éloigner des fréquences typiques de l'aéronef. Enfin, ces structures très simples à réaliser et à mettre en place ont un faible coût et peuvent facilement être standardiser pour un grand nombre de cartes électroniques différentes.

Plus précisément, l'invention a pour objet une carte électronique ayant une première face et une seconde face, lesdites faces comportant des renforts mécaniques, caractérisé en ce que lesdits renforts sont constitués d'une part d'une première structure haubanée disposée sur la première face et d'autre part, d'une seconde structure haubanée disposée sur la seconde face de ladite carte électronique.

L'invention sera mieux comprise et d'autres avantages apparaîtront à la lecture de la description qui va suivre donnée à titre non limitatif et grâce aux figures annexées parmi lesquelles :
- La figure 1 représente le schéma de principe d'un calculateur électronique.
- Les figures 2 et 3 représentent une vue de face et une vue en coupe d'une carte électronique comportant des raidisseurs mécaniques selon l'art antérieur.
- Les figures 4 et 5 représentent une vue de face et une vue en coupe d'une carte électronique comportant des structures haubanées selon l'invention.
- Les figures 6 et 7 représentent deux vues en coupe des structures haubanées selon un premier mode de réalisation.
- Les figures 8 et 9 représentent deux vues en coupe des structures haubanées selon un second mode de réalisation.
- La figure 10 représente une première configuration de structure haubanée selon l'invention.
- La figure 11 représente une seconde configuration de structure haubanée selon l'invention.

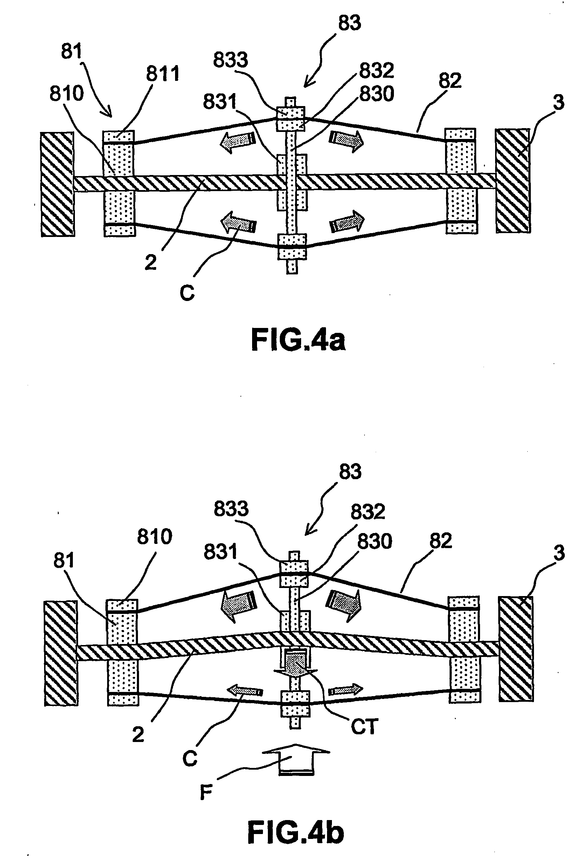

Le principe de l'invention est illustré en figure 4. Une première et une seconde structure haubanée 8 sont disposées sur la première face et la seconde face d'une carte électronique 2.

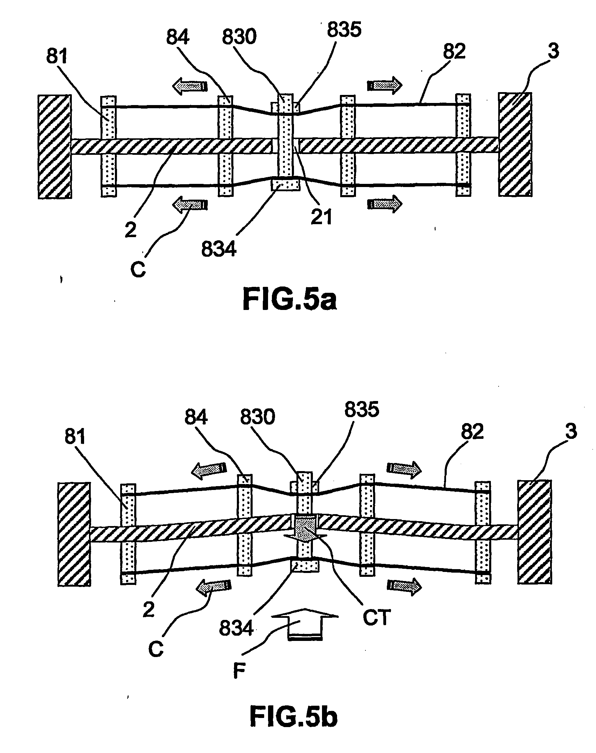

Comme il est montré sur la coupe AA de la figure 5, chaque structure haubanée comporte au moins une première entretoise périphérique 81, une deuxième entretoise périphérique 81 et un hauban 82 situés sur la même face de la carte électronique, chaque entretoise périphérique ayant une extrémité inférieure 810 solidaire de ladite face et une extrémité supérieure 811, lesdites extrémités supérieures 811 de la première et de la deuxième entretoise périphérique étant reliées entre elles par ledit hauban 82.

Le principe de fonctionnement est le suivant : les haubans sont mis sous tension mécanique de façon à placer la carte électronique sous contrainte mécanique. Les contraintes mécaniques supplémentaires apportées par les vibrations auront ainsi moins d'effet perturbateur. Pour que ces contraintes ne créent pas de flambage de la carte électronique, il est très important que les contraintes apportées par la seconde structure haubanée soient identique à celles apportées par la première structure haubanée. Ainsi, les contraintes résultantes sont situées dans le plan de la carte électronique. Si la disposition de la carte et l'implantation des composants le permet, la façon la plus simple d'obtenir cet effet est de choisir une seconde structure haubanée identique à la première et de la disposer sur la seconde face de façon sensiblement identique à la première structure haubanée disposée sur la première face.

Le hauban est soit un câble métallique de faible diamètre mis sous tenson, soit une lame métallique de faible épaisseur encore appelée « clinquant », également mise sous tension. Son épaisseur varie entre quelques dixièmes de millimètres et quelques millimètres.

Le hauban est mis sous tension mécanique soit par des moyens externes à la carte électronique, soit par des moyens internes à la structure haubanée, la tension mécanique sur le hauban étant réglable par lesdits moyens. Il est très avantageux d'avoir une tension réglable. En effet, les fréquences de résonance d'une carte électronique dépendent des contraintes qui lui sont appliquées. En modifiant la tension mécanique des haubans, on change ainsi les fréquences de résonance de la carte de sorte qu'elles soient différentes des fréquences propres de la structure ou de l'aéronef. On évite ainsi les phénomènes de surtension. Le décalage en fréquence peut atteindre plusieurs dizaines de pour cent de la fréquence de résonance initiale obtenue en l'absence de tensions mécaniques appliquées.

Lorsque les moyens de mise sous tension des haubans font partie intégrante de la structure haubanée, ils sont de deux types possibles :
- Type 1 : les moyens de mise sous tension du hauban de la seconde structure sont indépendants des moyens de mise sous tension du hauban de la première structure.
- Type 2: les moyens de mise sous tension mécanique sont communs aux haubans de chaque structure haubanée.

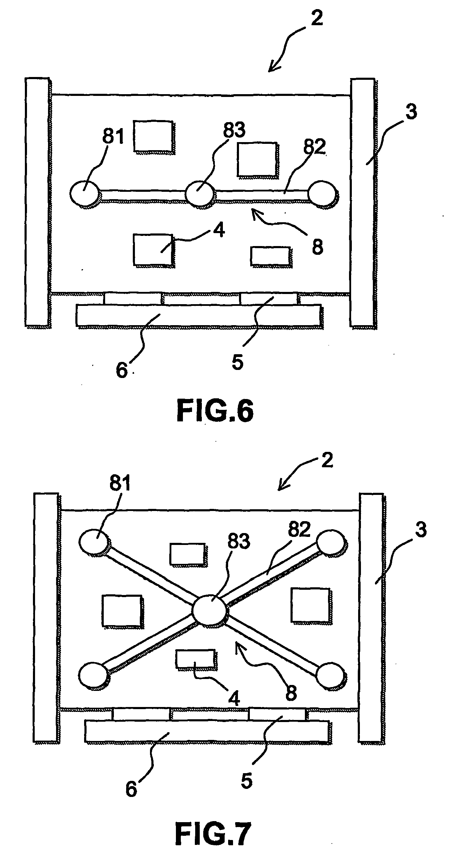

Les figures 6 et 7 représentent deux vues en coupe d'un exemple de structure haubanée de type 1. La figure 6 montre une vue en coupe de la structure au repos. La figure 7 montre une vue en coupe de la même structure lorsqu'elle est soumise à une sollicitation mécanique.

La partie hachurée de la figure 6 représente une vue en coupe de la carte électronique 2 et de ses deux glissières support 3. Sur chaque face de la carte électronique, une structure haubanée 8 est montée. Chaque structure haubanée comprend :
- Un hauban 82 qui est soit un câble métallique, soit une lame métallique ;
- Deux entretoises périphériques 81 comportant des pièces mécaniques 811 permettant de fixer le hauban 82 à ces deux extrémités ;
- Un ensemble de mise sous tension mécanique comprenant :
   - Un mât central 830 perpendiculaire à la carte électronique, l'extrémité inférieure dudit mât étant fixée sur la carte électronique au moyen d'une pièce mécanique 831. Pour des raisons de simplification et afin de rigidifier la structure, le mât central de chaque structure haubanée peut être unique et commun aux deux faces, comme indiqué sur la figure 4a. II traverse alors la carte électronique 2.
   - Un ensemble mécanique comprenant les pièces 832 et 833. Le hauban 82 est solidaire de la pièce 832 qui est mobile en translation le long de l'axe du mât, la pièce mécanique 833 vient bloquer le hauban 82 et la pièce 832. Avantageusement, pour réaliser les fonctions de translation et de blocage, le mât a une partie filetée et les pièces mécaniques 832 et 833 constituent un ensemble écrou-contre-écrou.

La mise sous tension mécanique du hauban 82 s'effectue de la façon suivante. On déplace la pièce mécanique 832 qui entraîne la partie centrale du hauban et crée des contraintes mécaniques C (flèches grises de la figure 6) sur le hauban. Ces contraintes se transmettent à la carte électronique au moyen des entretoises 81. Plus la pièce mécanique 832 est éloignée de la carte électronique, plus les contraintes appliquées sont importantes. Lorsque la contrainte souhaitée est obtenue, on bloque la pièce 832 au moyen de la pièce 833. Le réglage des contraintes est effectué sur la première et la seconde structure haubanée de façon que les contraintes appliquées sur la première et la seconde face soient équivalentes.

La figure 7 illustre le fonctionnement dynamique des structures haubanées. Lorsque la carte est en environnement vibratoire, elle est soumise à des forces périodiques qui tendent à la déformer. La figure 7 montre la carte électronique de la figure 6 déformée sous l'action d'une force F. La déformation de la carte entraîne une diminution des contraintes sur le hauban d'une des deux structures et une augmentation des contraintes sur le hauban de la structure haubanée opposée. La résultante des contraintes CT n'est plus nulle dans un plan perpendiculaire au plan de la carte électronique et s'oppose à l'action de la force appliquée F, diminuant ainsi son effet.

Lorsque les structures haubanées ont des moyens de mise sous tension indépendants, les contraintes appliquées aux haubans doivent être parfaitement maîtrisées afin de ne pas induire sur la carte électronique de contraintes parasites. En utilisant des moyens de mise sous tension communs, on résout cette difficulté. En effet, dans ce cas, les contraintes appliquées vont se répartir naturellement de façon symétrique sur les haubans de la première et de la seconde structure haubanée.

Les figures 8 et 9 représentent deux vues en coupe d'un exemple de structure haubanée de type 2. La figure 8 montre une vue en coupe de la structure au repos. La figure 9 montre une vue en coupe de la même structure lorsqu'elle est soumise à une sollicitation mécanique.

La partie hachurée de la figure 8 représente une vue en coupe de la carte électronique 2 et de ses deux glissières support 3. Sur chaque face de la carte électronique, une structure haubanée 8 est montée. Chaque structure haubanée comprend :
- Un hauban 82 qui est soit un câble métallique, soit une lame métallique ;
- Deux entretoises périphériques 81 comportant des pièces mécaniques 810 permettant de fixer le hauban 82 à ces deux extrémités ;
- un mât central 830 traversant librement la carte électronique à travers l'ouverture 21 et comportant une première et une seconde extrémité,
   - la première extrémité dudit mât étant située du côté de la première face, le hauban de la première structure étant solidaire de ladite première extrémité au moyen d'une pièce mécanique 834,
   - la seconde extrémité étant située du côté de la seconde face, la seconde extrémité portant un ensemble mécanique 835 solidaire du hauban de la seconde structure, ledit ensemble mécanique comportant des moyens de réglage en translation et de fixation le long du mât central, la partie centrale du hauban 82 de la seconde structure étant solidaire dudit ensemble mécanique,
- Au moins deux entretoises centrales 84 situées sur la première face, disposées de part et d'autre du mât central 830, chaque entretoise comportant une extrémité inférieure solidaire de ladite première face et une extrémité supérieure, le hauban 82 de la première structure haubanée reposant sur lesdites extrémités supérieures desdites entretoises centrales 84,
- Au moins deux entretoises centrales 84 situées sur la seconde face, disposées de part et d'autre du mât central 830, caque entretoise comportant une extrémité inférieure solidaire de ladite seconde face et une extrémité supérieure, le hauban 82 de la seconde structure haubanée reposant sur lesdites extrémités supérieures desdites entretoises centrales 84.

La mise sous tension mécanique du hauban 82 s'effectue de la façon suivante. On déplace la pièce mécanique 835 qui entraîne simultanément les parties centrales des haubans de la première et de la seconde structure et crée des contraintes mécaniques C (flèches grises de la figure 8) identiques sur chaque hauban. Ces contraintes se transmettent à la carte électronique au moyen des entretoises 81. Plus la pièce mécanique 835 se rapproche de la pièce mécanique 834, plus les contraintes appliquées sont importantes. Lorsque la contrainte souhaitée est obtenue, on bloque la pièce 835.

La figure 9 illustre le fonctionnement dynamique de ce type de structures haubanées. Lorsque la carte est en environnement vibratoire, elle est soumise à des forces périodiques qui tendent à la déformer. La figure 9 montre la carte électronique de la figure 8 déformée sous l'action d'une force F. La déformation de la carte entraîne une augmentation simultanée des contraintes sur les haubans des deux structures haubanées. La résultante des contraintes CT n'est plus nulle dans un plan perpendiculaire au plan de la carte électronique et s'oppose à l'action de la force appliquée F, diminuant ainsi son effet.

Les structures haubanées peuvent être implantées au centre de la carte parallèlement à ces bords comme il est indiqué en figure 10.

Elles peuvent être également implantées comme indiqué sur la figure 11. Dans ce cas, chaque structure haubanée comporte quatre entretoises disposées approximativement en rectangle et deux haubans, chaque hauban reliant deux entretoises situées sur une des deux diagonales du rectangle. Les moyens de mise sous tension mécanique sont alors communs aux haubans de chaque structure haubanée.

## Revendications

1. Carte électronique (2) ayant une première face et une seconde face, lesdites faces comportant des renforts mécaniques, **caractérisée en ce que** lesdits renforts sont constitués d'une part d'une première structure haubanée (8) disposée sur la première face et d'autre part, d'une seconde structure haubanée (8) disposée sur la seconde face de ladite carte électronique.

2. Carte électronique selon la revendication 1, **caractérisée en ce que** la seconde structure haubanée (8) est sensiblement identique à la première structure haubanée (8).

3. Carte électronique selon la revendication 2, **caractérisée en ce que** la seconde structure haubanée (8) est disposée sur la seconde face de façon sensiblement identique à la première structure haubanée (8) disposée sur la première face.

4. Carte électronique selon l'une des revendications précédentes, **caractérisée en ce que** chaque structure haubanée (8) comporte au moins une première entretoise périphérique (81), une deuxième entretoise périphérique (81) et un hauban (82) situés sur la même face de la carte électronique, chaque entretoise périphérique (81) ayant une extrémité inférieure (810) solidaire de ladite face et une extrémité supérieure (811), lesdites extrémités supérieures (811) de la première et de la deuxième entretoise périphérique (81) étant reliées entre elles par ledit hauban (82).

5. Carte électronique selon la revendication 4, **caractérisée en ce que** chaque structure haubanée (8) comporte quatre entretoises (81) disposées approximativement en rectangle et deux haubans (82), chaque hauban (82) reliant deux entretoises (81) situées sur une des deux diagonales du rectangle.

6. Carte électronique selon les revendications 4 et 5, **caractérisée en ce que** le hauban (82) comprend essentiellement un câble métallique de faible diamètre.

7. Carte électronique selon les revendications 4 et 5, **caractérisée en ce que** le hauban (82) comprend essentiellement une lame métallique de faible épaisseur.

8. Carte électronique selon l'une des revendications 6 ou 7, **caractérisée en ce que** chaque structure haubanée (8) comporte des moyens (83) de mise sous tension mécanique du hauban, ladite tension étant réglable par lesdits moyens.

9. Carte électronique selon les revendications 5 et 8, **caractérisée en ce que** les moyens (83) de mise sous tension mécanique sont communs aux haubans (82) de chaque structure haubanée (8).

10. Carte électronique selon la revendication 8, **caractérisée en ce que** les moyens (83) de mise sous tension du hauban de la seconde structure (8) sont indépendants des moyens (83) de mise sous tension du hauban de la première structure (8).

11. Carte électronique selon la revendication 10, **caractérisée en ce que** les moyens (83) de mise sous tension mécanique de chaque structure haubanée (8) comprennent un mât central (830) situé entre la première entretoise périphérique (81) et la deuxième entretoise périphérique (81), les deux entretoises périphériques (81) et le mât central (830) étant situés sur la même face de la carte électronique (2), ledit mât central (830) étant sensiblement perpendiculaire à ladite face, ledit mât central (830) ayant une extrémité inférieure (831) solidaire de la carte électronique et une extrémité supérieure portant un ensemble mécanique (832, 833) comportant des moyens de réglage en translation et de fixation le long du mât central, la partie centrale du hauban de ladite structure haubanée étant solidaire dudit ensemble mécanique (832, 833).

12. Carte électronique selon la revendication 11, **caractérisée en ce que** le mât central (830) comporte une partie filetée et que l'ensemble mécanique (832, 833) est du type écrou-contre-écrou.

13. Carte électronique selon la revendication 8, **caractérisée en ce que** les moyens (8) de mise sous tension sont communs au hauban (82) de la seconde structure et au hauban (82) de la première structure.

14. Carte électronique selon la revendication 13, **caractérisée en ce que** les moyens (8) communs de mise sous tension mécanique comprennent :
• un mât central (830) traversant la carte électronique (2) et comportant une première extrémité (834) et une seconde extrémité,
• la première extrémité (834) dudit mât étant située du côté de la première face, le hauban de la première structure étant solidaire de ladite première extrémité,
• la seconde extrémité étant située du côté de la seconde face, la seconde extrémité portant un ensemble mécanique (835) solidaire du hauban (82) de la seconde structure, ledit ensemble mécanique comportant des moyens de réglage en translation et de fixation le long du mât central, la partie centrale du hauban de la seconde structure étant solidaire dudit ensemble mécanique (835),
• Au moins deux entretoises centrales (84) situées sur la première face, disposées de part et d'autre du mât central (830), chaque entretoise comportant une extrémité inférieure solidaire de ladite première face et une extrémité supérieure, le hauban (82) de la première structure haubanée reposant sur lesdites extrémités supérieures desdites entretoises centrales (84),
• Au moins deux entretoises centrales (84) situées sur la seconde face, disposées de part et d'autre du mât central (830), chaque entretoise comportant une extrémité inférieure solidaire de ladite seconde face et une extrémité supérieure, le hauban (82) de la seconde structure haubanée reposant sur lesdites extrémités supérieures desdites entretoises centrales (84).

15. Carte électronique selon la revendication 14, **caractérisée en ce que** le mât central (830) comporte une partie filetée et que l'ensemble mécanique est essentiellement un écrou.

16. Calculateur électronique comportant au moins une carte électronique (2) selon l'une des revendications 1 à 15.

17. Système d'avionique ou d'hélivionique comportant au moins un calculateur électronique selon la revendication 16.

## Claims

1. Electronic card (2) having a first face and a second face, said faces including mechanical reinforcements, **characterized in that** said reinforcements are formed, on the one hand, from a first braced structure (8) placed on the first face and, on the other hand, from a second braced structure (8) placed on the second face of said electronic card.

2. Electronic card according to Claim 1, **characterized in that** the second braced structure (8) is substantially identical to the first braced structure (8).

3. Electronic card according to Claim 2, **characterized in that** the second braced structure (8) is placed on the second face in a substantially identical manner to the first braced structure (8) placed on the first face.

4. Electronic card according to one of the preceding claims, **characterized in that** each braced structure (8) comprises at least a first peripheral brace support (81), a second peripheral brace support (81) and a brace (82), these being located on the same face of the electronic card, each peripheral brace support (81) having a lower end (810) fastened to said face and an upper end (811), said upper ends (811) of the first and second peripheral brace supports (81) being joined together by said brace (82).

5. Electronic card according to Claim 4, **characterized in that** each braced structure (8) comprises four brace supports (81) spaced approximately in the form of a rectangle and two braces (82), each brace (82) joining two base supports (81) located on one of the two diagonals of the rectangle.

6. Electronic card according to Claims 4 and 5, **characterized in that** the brace (82) essentially comprises a small-diameter metal cable.

7. Electronic card according to Claims 4 and 5, **characterized in that** the brace (82) essentially comprises a thin metal blade.

8. Electronic card according to either of Claims 6 and 7, **characterized in that** each braced structure (8) includes means (83) for mechanically tensioning the brace, said tension being adjustable by said means.

9. Electronic card according to Claims 5 and 8, **characterized in that** the mechanical tensioning means (83) are common to the braces (82) of each braced structure (8).

10. Electronic card according to Claim 8, **characterized in that** the means (83) for tensioning the brace of the second structure (8) are independent of the means (83) for tensioning the brace of the first structure (8).

11. Electronic card according to Claim 10, **characterized in that** the means (83) for mechanically tensioning each braced structure (8) comprise a central mast (830) located between the first peripheral brace support (81) and the second peripheral brace support (81), the two peripheral brace supports (81) and the central mast (830) being located on the same face of the electronic card (2), said central mast (830) being approximately perpendicular to said face, said central mast (830) having a lower end (831), fastened to the electronic card, and an upper end carrying a mechanical assembly (832, 833) comprising means for translationally adjusting the brace along the central mast and for fixing it thereto, the central portion of the brace of said braced structure being fastened to said mechanical assembly (832, 833).

12. Electronic card according to Claim 11, **characterized in that** the central mast (830) has a threaded portion and **in that** the mechanical assembly (832, 833) is of the nut/jam-nut type.

13. Electronic card according to Claim 8, **characterized in that** the tensioning means (83) are common to the brace (82) of the second structure and to the brace (82) of the first structure.

14. Electronic card according to Claim 13, **characterized in that** the common mechanical tensioning means (83) comprise:
• a central mast (830) passing through the electronic card (2) and having a first end (834) and a second end:
• the first end (834) of said mast being located on the same side as the first face, the brace of the first structure being fastened to said first end; and
• the second end being located on the same side as the second face, the second end carrying a mechanical assembly (835) fastened to the brace (82) of the second structure, said mechanical assembly comprising means for translationally adjusting the brace along the central mast and for fixing it thereto, the central portion of the brace of the second structure being fastened to said mechanical assembly (835);
• at least two central brace supports (84) located on the first face, these being placed on either side of the central mast (830), each brace support having a lower end, fastened to said first face, and an upper end, the base (82) of the first braced structure resting on said upper ends of said central brace supports (84); and
• at least two central brace supports (84) located on the second face, these being placed on either side of the central mast (830), each brace support having a lower end, fastened to said second face, and an upper end, the brace (82) of the second braced structure resting on said upper ends of said central brace supports (84).

15. Electronic card according to Claim 14, **characterized in that** the central mast (830) has a threaded portion and **in that** the mechanical assembly is essentially a nut.

16. Electronic computer that includes at least one electronic card (2) according to one of Claims 1 to 15.

17. Fixed-wing or rotary-wing aircraft avionics system that includes at least one electronic computer according to Claim 16.

## Patentansprüche

1. Elektronikkarte (2) mit einer ersten Seite und einer zweiten Seite, wobei die Seiten mechanische Verstärkungen aufweisen, **dadurch gekennzeichnet, dass** die Verstärkungen einerseits aus einer ersten abgespannten Struktur (8), die auf der ersten Seite angeordnet ist, und andererseits aus einer zweiten abgespannten Struktur (8) bestehen, die auf der zweiten Seite der Elektronikkarte angeordnet ist.

2. Elektronikkarte nach Anspruch 1, **dadurch gekennzeichnet, dass** die zweite abgespannte Struktur (8) im Wesentlichen gleich der ersten abgespannten Struktur (8) ist.

3. Elektronikkarte nach Anspruch 2, **dadurch gekennzeichnet, dass** die zweite abgespannte Struktur (8) auf der zweiten Seite im Wesentlichen gleich der ersten abgespannten Struktur (8) angeordnet ist, die auf der ersten Seite angeordnet ist.

4. Elektronikkarte nach einem der vorhergehenden Ansprüche, **dadurch gekennzeichnet, dass** jede abgespannte Struktur (8) mindestens einen ersten peripheren Abstandshalter (81), einen zweiten peripheren Abstandshalter (81) und einen Abspanndraht (82) aufweist, die auf der gleichen Seite der Elektronikkarte angeordnet sind, wobei jeder periphere Abstandshalter (81) ein fest mit der Seite verbundenes unteres Ende (810) und ein oberes Ende (811) aufweist, wobei die oberen Enden (811) des ersten und des zweiten peripheren Abstandshalters (81) durch den Abspanndraht (82) miteinander verbunden sind.

5. Elektronikkarte nach Anspruch 4, **dadurch gekennzeichnet, dass** jede abgespannte Struktur (8) vier Abstandshalter (81), die in etwa in einem Rechteck angeordnet sind, und zwei Abspanndrähte (82) aufweist, wobei jeder Abspanndraht (82) zwei Abstandshalter (81) verbindet, die sich auf einer der zwei Diagonalen des Rechtecks befinden.

6. Elektronikkarte nach den Ansprüchen 4 und 5, **dadurch gekennzeichnet, dass** der Abspanndraht (82) im Wesentlichen ein Drahtseil geringen Durchmessers aufweist.

7. Elektronikkarte nach den Ansprüchen 4 und 5, **dadurch gekennzeichnet, dass** der Abspanndraht (82) im Wesentlichen ein Metallplättchen geringer Dicke aufweist.

8. Elektronikkarte nach einem der Ansprüche 6 oder 7, **dadurch gekennzeichnet, dass** jede abgespannte Struktur (8) Mittel (83) zum mechanischen Spannen des Abspanndrahts aufweist, wobei die Spannung von den Mitteln eingestellt werden kann.

9. Elektronikkarte nach den Ansprüchen 5 und 8, **dadurch gekennzeichnet, dass** die Mittel (83) zum mechanischen Spannen den Abspanndrähten (82) jeder abgespannten Struktur (8) gemeinsam sind.

10. Elektronikkarte nach Anspruch 8, **dadurch gekennzeichnet, dass** die Mittel (83) zum Spannen des Abspanndrahts der zweiten Struktur (8) von den Mitteln (83) zum Spannen des Abspanndrahts der ersten Struktur (8) unabhängig sind.

11. Elektronikkarte nach Anspruch 10, **dadurch gekennzeichnet, dass** die Mittel (83) zum mechanischen Spannen jeder abgespannten Struktur (8) einen zentralen Mast (830) aufweisen, der sich zwischen dem ersten peripheren Abstandshalter (81) und dem zweiten peripheren Abstandshalter (81) befindet, wobei die zwei peripheren Abstandshalter (81) und der zentrale Mast (830) sich auf der gleichen Seite der Elektronikkarte (2) befinden, wobei der zentrale Mast (830) im Wesentlichen lotrecht zur Seite ist, wobei der zentrale Mast (830) ein fest mit der Elektronikkarte verbundenes unteres Ende (831) und ein oberes Ende aufweist, das eine mechanische Einheit (832, 833) trägt, die Mittel zur Einstellung der Translationsverschiebung und zur Befestigung entlang des zentralen Masts aufweist, wobei der zentrale Bereich des Abspanndrahts der abgespannten Struktur fest mit der mechanischen Einheit (832, 833) verbunden ist.

12. Elektronikkarte nach Anspruch 11, **dadurch gekennzeichnet, dass** der zentrale Mast (830) einen Gewindebereich aufweist, und dass die mechanische Einheit (832, 833) vom Typ Mutter-Gegenmutter ist.

13. Elektronikkarte nach Anspruch 8, **dadurch gekennzeichnet, dass** die Spannmittel (83) dem Abspanndraht (82) der zweiten Struktur und dem Abspanndraht (82) der ersten Struktur gemeinsam sind.

14. Elektronikkarte nach Anspruch 13, **dadurch gekennzeichnet, dass** die gemeinsamen Mittel (83) zum mechanischen Spannen aufweisen:
• einen zentralen Mast (830), der die Elektronikkarte (2) durchquert und ein erstes Ende (834) und ein zweites Ende aufweist,
• wobei das erste Ende (834) des Masts sich auf der Seite der ersten Seite befindet, wobei der Abspanndraht der ersten Struktur fest mit dem ersten Ende verbunden ist,
• wobei das zweite Ende sich auf der Seite der zweiten Seite befindet, wobei das zweite Ende eine mechanische Einheit (835) trägt, die fest mit dem Abspanndraht (82) der zweiten Struktur verbunden ist, wobei die mechanische Einheit Mittel zur Einstellung der Translationsverschiebung und zur Befestigung entlang des zentralen Masts aufweist, wobei der zentrale Bereich des Abspanndrahts der zweiten Struktur fest mit der mechanischen Einheit (835) verbunden ist,
• mindestens zwei zentrale Abstandshalter (84), die sich auf der ersten Seite zu beiden Seiten des zentralen Masts (830) angeordnet befinden, wobei jeder Abstandshalter ein fest mit der ersten Seite verbundenes unteres Ende und ein oberes Ende aufweist, wobei der Abspanndraht (82) der ersten abgespannten Struktur auf den oberen Enden der zentralen Abstandshalter (84) ruht,
• mindestens zwei zentrale Abstandshalter (84), die sich auf der zweiten Seite zu beiden Seiten des zentralen Masts (830) angeordnet befinden, wobei jeder Abstandhalter ein fest mit der zweiten Seite verbundenes unteres Ende und ein oberes Ende aufweist, wobei der Abspanndraht (82) der zweiten abgespannten Struktur auf den oberen Enden der zentralen Abstandshalter (84) ruht.

15. Elektronikkarte nach Anspruch 14, **dadurch gekennzeichnet, dass** der zentrale Mast (830) einen Gewindebereich aufweist, und dass die mechanische Einheit im Wesentlichen eine Mutter ist.

16. Elektronischer Rechner, der mindestens eine Elektronikkarte (2) nach einem der Ansprüche 1 bis 15 aufweist.

17. Flugzeugelektronik- oder Helikopterelektronik-System, das mindestens einen elektronischen Rechner nach Anspruch 16 aufweist.
